(19) Europäisches Patentamt
European Patent Office
Office européen des brevets

(11) **EP 4 495 297 B1**

(12) **EUROPÄISCHE PATENTSCHRIFT**

(45) Veröffentlichungstag und Bekanntmachung des Hinweises auf die Patenterteilung:
**24.12.2025 Patentblatt 2025/52**

(21) Anmeldenummer: **23186156.8**

(22) Anmeldetag: **18.07.2023**

(51) Internationale Patentklassifikation (IPC):
**C30B 15/04** (2006.01)   **C30B 15/20** (2006.01)
**C30B 29/06** (2006.01)

(52) Gemeinsame Patentklassifikation (CPC):
**C30B 29/06; C30B 15/04; C30B 15/20**

(54) **VERFAHREN ZUM KRISTALLZIEHEN EINES DOTIERTEN MONOKRISTALLINEN KRISTALLS AUS SILICIUM**

METHOD FOR CRYSTAL GROWTH OF DOPED MONOCRYSTALLINE SILICON CRYSTAL

PROCÉDÉ DE CROISSANCE CRISTALLINE D'UN CRISTAL MONOCRISTALLIN DOPÉ DE SILICIUM

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(43) Veröffentlichungstag der Anmeldung:
**22.01.2025 Patentblatt 2025/04**

(73) Patentinhaber: **Siltronic AG**
**81677 München (DE)**

(72) Erfinder: **Kadinski, Lev**
**84489 Burghausen (DE)**

(56) Entgegenhaltungen:

• MUKAIYAMA YUJI ET AL: "Evaluation of numerical simulation of constitutional supercooling during heavily Boron-Doped silicon crystal growth using Cz method", JOURNAL OF CRYSTAL GROWTH, ELSEVIER, AMSTERDAM, NL, vol. 619, 20 June 2023 (2023-06-20), XP087356617, ISSN: 0022-0248, [retrieved on 20230620], DOI: 10.1016/ J.JCRYSGRO.2023.127333
• MUKAIYAMA YUJI ET AL: "Unsteady numerical simulations considering effects of thermal stress and heavy doping on the behavior of intrinsic point defects in large-diameter Si crystal growing by Czochralski method", JOURNAL OF CRYSTAL GROWTH, ELSEVIER, AMSTERDAM, NL, vol. 532, 16 December 2019 (2019-12-16), XP085989813, ISSN: 0022-0248, [retrieved on 20191216], DOI: 10.1016/ J.JCRYSGRO.2019.125433
• MUKAIYAMA YUJI ET AL: "Numerical analysis of constitutional supercooling in heavily doped silicon crystals grown using the Czochralski method", vol. 597, 1 November 2022 (2022-11-01), AMSTERDAM, NL, pages 126844, XP093100364, ISSN: 0022-0248, Retrieved from the Internet <URL:https://www.sciencedirect.com/science/ article/pii/S0022024822003281/pdfft? md5=ac7712b0831dac14a9b6df0b63772dcd& pid=1-s2.0-S0022024822003281-main.pdf> DOI: 10.1016/j.jcrysgro.2022.126844

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren zum Ziehen eines dotierten Einkristalls aus Silicium.

Das Züchten von Kristallen ist eine wichtige Vorstufe zur Herstellung von Halbleiterbauelementen. Halbleiterkristallzuchtverfahren wurden verbessert, um einkristalline Halbleiterblöcke zu erhalten, die beispielsweise einen Durchmesser von 200 mm bis 300 mm und eine Länge von mehr als zwei Metern haben können.

Bauelemente zur Steuerung von großen Strömen (Leistungsbauelemente) bedürfen hoch dotierte Silicium Kristalle, die zu den entsprechenden Bauelementen weiterverarbeitet werden.

Eine der Herausforderungen bei der Züchtung von stark dotiertem Silizium mit der Czochralski-Methode ist die Erhöhung der maximalen Dotierungskonzentration oder die Verringerung des minimalen Widerstands, ohne dabei die Ausbeute der nutzbaren Kristalle zu reduzieren.

**Stand der Technik**

DE 10 2019 210 254 A1 beschreibt ein Verfahren zum Ziehen eines Einkristalls aus Silicium, der einen spezifischen Widerstand von nicht mehr als $20 \times 10^{-3}$ Ohm cm aufweist, wobei die erste Phase des Kristallzüchtungsprozesses optimiert wird, mit dem Ziel die Wahrscheinlichkeit des Auftretens von Versetzungen zu reduzieren.

Die EP 3 864 197 A1 beschäftigt sich mit einem Verfahren zum Kontrollieren der Konzentration des Dotierstoffes in der Schmelze, mit dem Ziel das Auftreten von Versetzungen zu reduzieren.

Die DE 10 2021 206 550 A1 beschreibt ein Verfahren zum Ziehen eines Einkristalls mit einem sehr kleinen Widerstand unter Verwendung eines Magnetfeldes.

Y. Mukaiyama et al., J. Cryst. Growth, 619 (2023), 127333, offenbart eine dreidimensionale numerische Simulation zur Vorhersage der konstitutionellen Unterkühlung während des Wachstums von stark B-dotierten Czochralski-Si-Einkristallen unter Berücksichtigung des B-Transports in der Schmelze und des Segregationseffekts.

Y. Mukaiyama et al., J. Cryst. Growth, 532 (2020), 125433, offenbart unstetige Simulationen der Dynamik intrinsischer Punktdefekte unter Berücksichtigung der Auswirkungen der thermischen Spannung und der Dotierstoffkonzentration in einem Siliziumkristall mit großem Durchmesser, der nach der Czochralski-Methode wächst.

Das Phänomen der konstitutionellen Unterkühlung ist bei einem relativ niedrigen Dotierungsniveau, das im Allgemeinen für die Züchtung von Halbleiterkristallen verwendet wird, zunächst nicht problematisch.

Jedoch während des Kristallwachstums aus einer stark dotierten Schmelze -wobei die Dotierstoffe einen kleinen Gleichgewichtssegregationskoeffizienten haben, der viel kleiner als eins ist - kann es in der Schmelze an der Grenzfläche zwischen Schmelze und Kristall zu einer konstitutionellen Unterkühlung kommen. Dies führt dazu, dass der Stab versetzt und nicht mehr für den Bauelementprozess verwendbar ist.

Ein Prozess zum Ziehen von Kristallen kann auf sehr mannigfacher weise modifiziert werden, um Kristalle mit moderatem Dotierstoffniveau herzustellen. Beispielsweise können Kristallrotation, Tiegelrotation, Magnetfeldposition und -stärke, Abstände zwischen verschiedenen Einbauteilen, um nur einige wenige zu nennen.

Soll das Dotierstoffniveau erhöht, also der Widerstand im Kristall weiter abgesengt werden, zeigt sich, dass viele Prozesse, die mit hohem Widerstand problemlos herzustellen sind, versetzen, also Ausschuss sind.

Den genannten Stellen im Stand der Technik gemein ist, dass sie kein zielgerichtetes Verfahren aufzeigen, wie Prozesse dahingehend zu optimieren sind. Es müssen viele teure Experimente unternommen werden, bei denen a priori nicht klar ist ob zum einen der entsprechende Kristall den Anforderungen genügt und zum anderen der vorgeschlagene Prozess auch stabil genug geeignete Kristalle hervorbringt.

Aufgabe dieser Erfindung ist es daher, ein Verfahren zur Verfügung zu stellen, das es ermöglicht Kristallziehprozesse dahingehend zu modifizieren, dass sie ein hohes Dotierstoffniveau aufweisen und gleichzeitig den Qualitätsansprüchen genügen bei gleichzeitigem reduziertem experimentellen Aufwand.

Gelöst wird diese Aufgabe durch die in den Ansprüchen beschriebenen Verfahren.

**Kurzbeschreibung der Figuren**

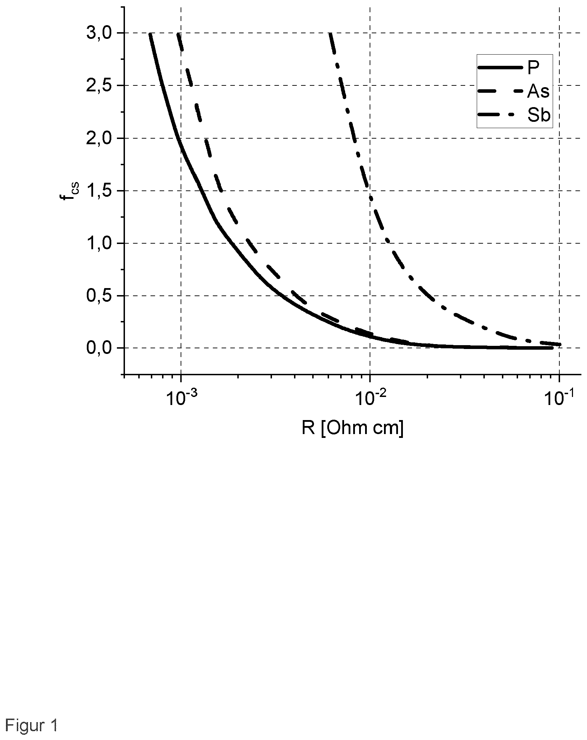

**Figur 1** zeigt den Faktor $f_{CS}$ als Funktion des spezifischen Widerstands für die Dotierstoffe Phosphor (P), Arsen (As) und Antimon (Sb).

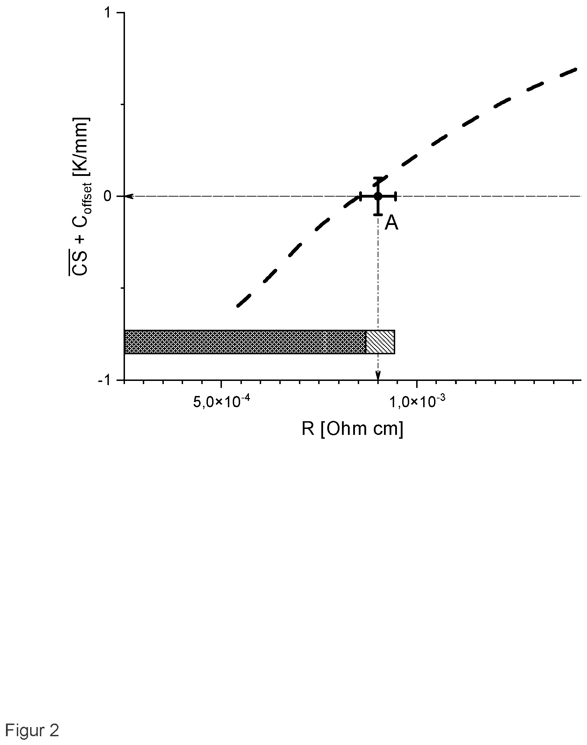

**Figur 2** zeigt die Summe aus dem simulierten Parameter $\overline{CS}$ und einer Offsetkonstante $C_{Offset}$ für einen Beispielprozess A dargestellt als Funktion des Widerstandes (gestrichelte Kurve). Der Grenzwiderstand, bei dem der Kristall gerade noch ziehbar ist, wird ermittelt, indem der Widerstand so lange variiert wird, bis die Kurve aus der Summe aus dem simulierten Parameter $\overline{CS}$ am Tripelpunkt des simulierten Kristalls und der Offsetkonstante $C_{Offset}$ null wird.

Der eingezeichnete dunkel gefärbte Balken soll den Bereich zeigen, bei welchem Widerstandsbereich ein Kristallziehen aussichtslos ist. Realistischerweise gibt es einen kleinen Übergangsbereich (hell schraffiert), bei dem ein Kristallziehen mit hohem Risiko möglich ist, jedoch aus wirtschaftlichen Gründen nicht zu empfehlen ist.

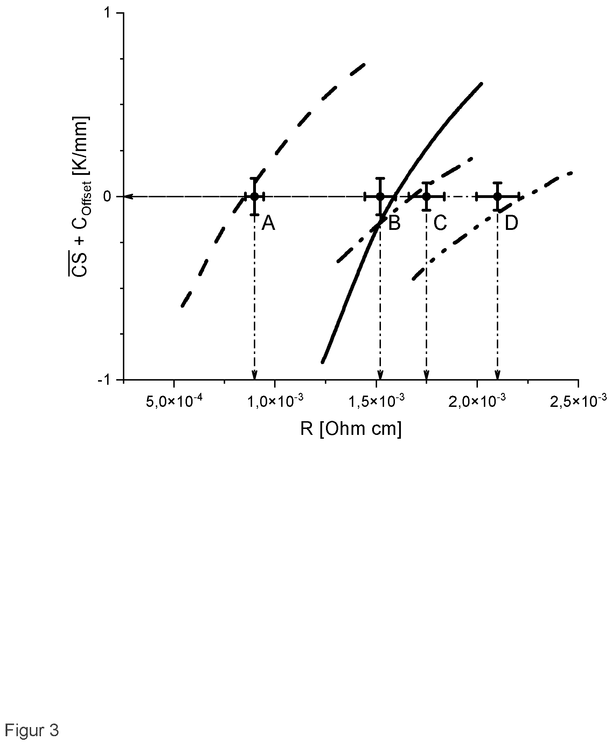

**Figur 3** zeigt die Summe aus dem simulierten Parameter $\overline{CS}$ am Tripelpunkt des jeweiligen Kristalls und einer Offsetkonstante $C_{Offset}$ für vier Beispielprozesse (**A** "gestrichelt", **B** "voll", **C** "strichpunkt", **D** "strichpunktpunkt") jeweils dargestellt als Funktion des Widerstandes.

Die jeweiligen Grenzwiderstände, bei dem ein Kristall gerade noch ziehbar ist, wurde durch die nach unten gerichteten Pfeile auf die Abszissenachse symbolisiert.

## Detaillierte Beschreibung der Erfindung

Wie bereits erwähnt, ist das Phänomen der konstitutionellen Unterkühlung bei einem relativ niedrigen Dotierungsniveau, das im Allgemeinen für die Züchtung von Halbleiterkristallen verwendet wird, zunächst nicht problematisch. Erst die Erhöhung der gewünschten Dotierstoffkonzentration kann zur konstitutionellen Unterkühlung und damit zu einer hohen Wahrscheinlichkeit für Versetzungen und damit zum Totalausfall des jeweiligen Kristalls führen.

Die Erfinder haben unter anderem erfolgreich versucht, eine erheblich modifizierte Computersimulationsmethode einzusetzen, um das genannte Problem einzugrenzen und zu lösen.

Der physikalische Effekt der konstitutionellen Unterkühlung ist zum Beispiel in der Dissertation von L. Stockmeier (ISBN 978-3-8396-1345-0, "Heavily n-type doped silicon and the dislocation formation during its growth by the Czochralski method") beschrieben.

Das zugrundeliegende mathematische Modell zur numerischen Modellierung dieses Problems zusammen mit einer geeigneten Software sind in den notwendigen Einzelheiten in Mukaiyama et al. [Y. Mukaiyama, V. Artemyev, K. Sueoka, J. Crystal Growth, 597 (2022) 126844, https://doi.org/10.1016/j.jcrysgro.2022.126844] beschrieben.

Die Erfinder haben erkannt, dass wesentliche Anpassungen notwendig sind, um signifikante Verbesserungen in der Ausbeute zu erzielen. Diese wesentlichen Anpassungen werden im Folgenden erläutert.

Ein Wert **CS,** der an der Grenzfläche zwischen Schmelze und Kristall berechnet wird, wird dabei definiert als:

$$CS = \frac{\partial T}{\partial n} - f_{CS}\frac{\partial c}{\partial n},$$

wobei $\frac{\partial T}{\partial n}$ die partielle Ableitung der Temperatur und $\frac{\partial c}{\partial n}$ die partielle Ableitung der Konzentration des Dotierstoffs entlang der Normalen auf der Grenzfläche zwischen Kristall und Schmelze in der Schmelze darstellt.

Der Faktor $f_{CS}$ stellt dabei eine Funktion des spezifischen Widerstands und der Materialeigenschaften des Dotierstoffs dar und kann mit Hilfe von Materialdatenkonstanten und dem Diagramm "Dichte/Widerstand" des Dotierstoffs (*SEMI* Standard *MF723*-0307, 2012 Practice for conversion between resistivity and dopant or carrier density for boron-doped, phosphorus-doped, and arsenic-doped silicon) ermittelt werden.

In **Figur 1** ist dieser Faktor $f_{CS}$ als Funktion des spezifischen Widerstands für unterschiedliche Dotierstoffe wie Phosphor, Arsen oder Antimon dargestellt. Es ist einfach möglich, auch für andere Dotierstoffe diesen Faktor zu bestimmen und damit ist das erfinderische Verfahren nicht auf diese Dotierstoffe limitiert.

Die numerischen Unterschiede in $f_{CS}$ für verschiedene Dotierstoffe sind auf Unterschiede im ionisierten Anteil des Dotierstoffs und in den Segregationskoeffizienten zurückzuführen. Die Materialeigenschaften können dabei den Unterschied für Phosphor (P), Arsen (As) und Sb als Dotierstoffe erklären.

Im Folgenden werden die modifizierten Randbedingungen für den Wärmetransport und den Transport von Dotierstoffen für die Modellierung erläutert.

Für die durchgeführten 3D-Simulationen wurde die Temperatur an der Grenzfläche zwischen Kristall und Schmelze als konstant angenommen.

Die Erfinder haben erkannt, dass die Randbedingungen für die Konzentration (Entmischungsrandbedingungen) aus Mukaiyama et al. [Y. Mukaiyama, V. Artemyev, K. Sueoka, J. Crystal Growth, 597 (2022) 126844,]] für eine positive Kristallisationsrate gültig sind.

$$-\rho_{melt}D_{melt}\frac{\partial c}{\partial n} = \rho_{crys}V_{crys}c_{melt}(1-k), \; c_{crys} = kc_{melt}$$

Die Erfinder haben ferner erkannt, dass im Falle einer negativen Kristallisationsrate (=Schmelzen) bevorzugt durch folgende Gleichung ersetzt wird:

$$-\rho_{melt} D_{melt} \frac{\partial c}{\partial n} = \rho_{crys} V_{crys} \left( c_{melt} - c_{crys} \right)$$

Dabei ist c die Massenkonzentration, $\rho_{melt}$ die Dichte der Schmelze, $D_{melt}$ der Diffusionskoeffizient des Dotierstoffes in der Schmelze, $c_{crys}$ die Konzentration der Dotierstoffe im Kristall und n die Normale zur Grenzfläche an der Schmelz- bzw. Wachstumsfront.

Der Parameter $c_{crys}$ ist ein aus den aktuellen Berechnungen bekannter Wert, wenn die Kristallisationsrate positiv ist, und er eine Funktion der Kristalllänge ist.

In vorliegender Erfindung wurde sein Wert durch die durchschnittliche Dotierstoffkonzentration im Kristall approximiert. Es hat sich herausgestellt, dass die genauen Werte von $c_{crys}$ für die Berechnung nicht notwendig sind. Zudem ist es schwierig, sie in die Software zu implementieren.

Eine experimentelle Form der Grenzfläche zwischen Schmelze und Kristall kann ermittelt werden, indem ein zu untersuchendes Kristallstück mittels zweier Längsschnitte, die entlang des Zentrums des Kristallstückes geführt werden, eine rechteckige Scheibe (ein sogenanntes Brett) herausgeschnitten werden. Dieses Brett kann dann bezüglich Widerstandsschwankungen untersucht werden. Der zugegebene Dotierstoff baut sich in den Kristall unregelmäßig ein. Bevorzugt enthält dabei der Dotierstoff Bor oder Phosphor. Dies führt zu einer lokal inhomogenen Widerstandsverteilung des Siliciums, die "Striations" genannt wird. Obwohl es große Anstrengungen gibt, Striations zu vermeiden, um negative Auswirkungen beim Bauelementprozess nicht zu erleiden, sind dennoch Striations am dotierten Stab immer messbar. Da sich der Dotierstoff von der Schmelze in den Kristall entlang der Grenzfläche Schmelze/Kristall einbaut, lässt sich mittels der Analyse der gemessenen Widerstandsverteilung die ursprüngliche Form der Grenzfläche zwischen Kristall und Schmelze in Form von Wachstumsstreifen ermitteln.

Für die Simulation sind instationäre 3D-Simulationen notwendig, bei denen es zwei Möglichkeiten gibt, sie durchzuführen:
Entweder wird die Form der Grenzfläche zwischen Kristall und Schmelze durch Anpassen der Stefan-Randbedingung so angepasst, dass sie der Realität entsprechen, oder die Form der Grenzfläche wird fixiert, wobei in Kauf genommen wird, dass die Stefan-Bedingung nicht unbedingt erfüllt ist.

Beide Ansätze können unter bestimmten Bedingungen für die Berechnungen ungeeignet sein. Im ersten Fall kann die Grenzfläche von der experimentellen abweichen, was sich auf die Berechnungen der Strömung und der Spezies auswirkt. Im zweiten Fall wäre die berechnete Kristallisationsrate falsch und dementsprechend auch die Verteilung der Spezies an der Grenzfläche, da sie den Entmischungsrandbedingungen folgt.

Um diese Schwierigkeit zu vermeiden, haben die Erfinder erkannt, dass sowohl die Berechnungen mit der berechneten Grenzfläche durchzuführen sind und gleichzeitig künstliche Wärmequellen einzuführen sind, um sowohl die vorgeschriebene Grenzflächenform als auch die korrekte Kristallisationsrate zu erhalten.

Dieses Verfahren ist auch deshalb vorteilhaft, da sie Fluktuationen der Kristallisationsrate und der Dotierstoffspezies um die korrekten gemittelten Werte zulässt.

Dieses Verfahren kann zum Beispiel mit Hilfe einer modifizierten Version der Software CGSim von STR (https://str-soft.com) implementiert werden.

Es wurden exemplarisch vier Fälle für die Berechnungen ausgewählt.

Die ersten beiden Fälle stammen aus zwei verschiedenen Prozessen für 200 mm Kristalldurchmesser für Arsen (Prozess A) und roten Phosphor (Prozess B). Die zwei weiteren Prozesse sind beide mit Arsen dotiert und haben einen Kristalldurchmesser von 300mm und werden im Folgenden als Prozess C und Prozess D bezeichnet. Der Unterschied zwischen Prozesse C und D liegen in der Verwendung unterschiedlicher Kristallziehvorrichtungen und unterschiedlichen Ziehgeschwindigkeiten nebst unterschiedlichen Kristall- und Tiegelrotationen.

Die Erfinder haben festgestellt, dass die statistisch gemittelten niedrigsten möglichen Widerstände für die Prozesse mit 200 mm 0,9 x $10^{-3}$ Ohm cm für Prozess A und 1,7 x $10^{-3}$ Ohm cm für Prozess B betragen. Für die Prozesse mit 300 mm liegen diese Widerstände bei 1,75 x $10^{-3}$ Ohm cm (Prozess C) und 2,1 x $10^{-3}$ Ohm cm (Prozess D).

Alle diese experimentellen Werte gelten jeweils für eine bestimmte Position im Kristall und die Berechnungsfälle wurden entsprechend dieser einen entsprechenden Position ausgewählt.

Es ist zu beachten, dass ermittelten Widerstandswerte Durchschnittswerte vieler realer Experimente darstellen und dass die Ergebnisse jedes Experiments von Prozess zu Prozess unterschiedlich streuen und einige Experimente z.B. aufgrund von Versetzungen erfolglos sind.

Bisher ist der konkrete kausale Zusammenhang zwischen dem Auftreten von Versetzungen und der Höhe der Dotierstoffkonzentration nicht bekannt.

Dennoch bietet das erfinderische Verfahren Mittel in die Hand, das Problem zumindest zu verhindern.

Die Erfinder gehen davon aus, dass CS mit diesen experimentellen Ergebnissen in Verbindung stehen könnte.

Der oben definierte Parameter CS kann unter Verwendung des Tiller-Kriteriums wie folgt berechnet werden:

$$\frac{CS}{V} = \frac{G_L}{V} - \frac{(1-k) \cdot C_0 \cdot (-m_l)}{k \cdot D_L}$$

wobei $C_0$ - Konzentration in der Schmelze, k - Segregationskoeffizient, $D_L$ - Diffusionskoeffizient in der Schmelze, V - Kristallisationsgeschwindigkeit, $G_L$ - Temperaturgradient in der Schmelze und $m_l$ - Steigung der Liquiduslinie ist.

Der Parameter $G_L$ kann dabei zum Beispiel aus den entsprechenden 2D-Simulationen übernommen werden.

Der Theorie nach würde immer dann, wenn die Bedingung CS < 0 erfüllt ist, eine konstitutionelle Unterkühlung stattfinden und der entsprechend gezogene Stab unbrauchbar werden.

Dies stellte sich aber als nichtzutreffend heraus. Das heißt eine einfache Analyse mittels des bekannten "Tillerkriteriums" ist nicht möglich und ist somit unbrauchbar.

Die Erfinder schlossen daraus, dass weitere Maßnahmen notwendig sind.

Die Erfinder haben erkannt, dass das verwendete numerische Gitter bei allen 3D Simulationen die Konzentrationsgrenzschicht adäquat auflösen muss.

In den Simulationen ist es bevorzugt, dass der Abstand des nächsten Kontrollvolumens zur Grenzfläche aus Kristall und Schmelze maximal 0,125 mm beträgt.

Die vollständigen numerische Gitter bei den besagten Beispielen variierten von etwa 3 Millionen Kontrollvolumina bis 3,8 Millionen Kontrollvolumina.

Als Ergebnis der 3D-Simulationen erhält man die momentane Verteilung von CS-Werten an jeder Position an der Grenzfläche zwischen Kristall und Schmelze. Diese Punkte befinden sich auf dem Kristall, der über der Schmelze rotiert.

Für die weiteren Berechnungen wurden CS-Werte, die auf Punkten mit gleichem Abstand zum Mittelpunkt der Interfacefläche des Kristalls berechnet wurden, gemittelt.

Man erhält also eine radiale Verteilung der CS-Werte als Funktion der Zeit.

Bei der Untersuchung der ermittelten CS-Werte an unterschiedlichen Radien fiel den Erfindern auf, dass offenbar die kleineren Werte offenbar eher im Bereich des Tripelpunktes auftreten und in der Mitte des Kristalls die CS-Werte eher nicht oder erheblich weniger oft im negativen Bereich liegen. Dies würde bedeuten, dass die konstitutionelle Unterkühlung im Tripelpunkt ihren Ausgangspunkt hat.

Experimentelle Befunde von Mukaiyamaet al. [Y. Mukaiyama, V. Artemyev, K. Sueoka, J. Crystal Growth, 597 (2022) 126844.] zeigen jedoch im Gegensatz dazu, dass die Folgen der konstitutionellen Unterkühlung eher im Zentrum des Kristalls beginnen.

Trotz dieses offensichtlichen Widerspruchs haben die Erfinder ihr Ergebnis weiter angewandt und kamen zu einer Methode, die mit Hilfe der Simulation eine mögliche Eignung eines Kristallziehprozesses für einen niedrigen Widerstand vorhersagt.

Mit dieser Methode ist es möglich Kristallziehparameter so zu modifizieren, dass Kristalle mit niedrigeren Widerstände verlustfrei zu ziehen sind.

Das erfinderische Verfahren zum Kristallziehen eines monokristallinen Kristalls aus einer Schmelze und einem Dotierstoff nach dem Czochralski Verfahren enthält dabei folgend Schritte:

(a) das Durchführen einer zeitabhängigen Computersimulation eines vordefinierten Kristallziehprozesses mit einer vordefinierten Dotierstoffkonzentration C in der Schmelze, mit dem Ziel für jeden Zeitschritt t einen Temperaturgradienten $\partial T/\partial n$, und einen Gradienten des Dotierstoffes $\partial c/\partial n$ zu erhalten, wobei beide Gradienten an der Grenzfläche zwischen Kristall und Schmelze in Richtung der Normalen der Grenzfläche zur Schmelze hin ermittelt werden,

(b) das Ermitteln einer maximalen Dotierstoffkonzentration $C_{max}$ in der Schmelze und

(c) das Ziehen eines Einkristalls mit Dotierstoffkonzentration kleiner als der ermittelten maximalen Dotierstoffkonzentration $C_{max}$,

Das erfinderische Verfahren enthält zudem die Berechnung einer Größe CS, die für jeden Zeitschritt t, die bestimmt wird durch die folgende Formel:

$$CS = \partial T/\partial n - f_{CS}\ \partial c/\partial n$$

wobei der Parameter $f_{CS}$ bestimmt wird durch das Produkt aus der mittleren Konzentration des Dotierstoffes in der Schmelze, der Dichte der Siliziumschmelze, der Avogadrokonstante, der molare Masse von Silicium und der Steigung der Liquiduslinie.

Anschließend wird ein zeitlicher Mittelwert CS aus den erhaltenen Werten der CS-Werte gebildet, wobei nur diejenigen Werte CS einen Beitrag leisten, die kleiner sind als Null. Die zeitliche Mittelung kann berechnet werden mit der Formel $\overline{CS} = \frac{1}{T_1 - T_0} \int_{T_0}^{T_1} CS(\tau)\, d\tau, \forall\, CS\,(\tau) < 0$ , wobei $T_0$ und $T_1$ die absoluten zeitlichen Beginn und Endpunkte darstellen.

Bevorzugt wird die Mittelung über 30 Minuten physikalischer Zeit oder mehr angewandt.

Der Mittelwert CS ist demnach eine Funktion des Radius und der Konzentration des Dotierstoffes C in der Schmelze. Zudem ist er nunmehr unabhängig von der Zeit.

Für das weitere Verfahren wird der Mittelwert CS an einer radialen Position des Kristalls ausgewählt. Bevorzugt wird hierbei der CS am Tripelpunkt des Kristalls verwendet, also beim Nennradius des Kristalls.

Das Ermitteln einer maximalen Dotierstoffkonzentration $C_{max}$ erfolgt durch das Anpassen der Dotierstoffkonzentration C so lange, bis der Betrag von CS gleich Null ist, bevorzugt bis der Betrag von CS - $C_{Offset}$ gleich null ist, wobei die Konstante $C_{Offset}$ bevorzugt experimentell ermittelt wird.

## Das Bestimmen der Konstante $C_{Offset}$

Wird die Konstante $C_{Offset}$ mit null vorbelegt, erhält man eine untere Grenze für den Dotierstoff $C_{max}$, unter der es in jedem Fall möglich ist, einen Kristall ohne Ausbeuteverluste zu ziehen.

In manchen Fällen kann es sein, dass diese untere Grenze jedoch zu konservativ erscheint, das heißt, dass ein Kristallziehen mit einer Dotierstoffkonzentration auch noch oberhalb dieser Grenze möglich ist.

Für solche Fälle wird ein $C_{Offset}$ bevorzugt unter Zuhilfenahme experimenteller Daten wie folgt bestimmt.

Es wird für einen Kristallziehprozess eine empirische Grenze beispielsweise ermittelt, indem einer oder mehrere Kristalle gezogen werden, wobei sukzessive die Dotierstoffkonzentration erhöht wird, solange bis der Kristall reproduzierbar Versetzungen aufweist. Diese so ermittelte empirische Grenze wird verwendet, um die Konstante $C_{Offset}$ zu erhalten.

Diese so erhaltene Konstante $C_{Offset}$ kann nun verwendet werden, um beispielsweise viele unterschiedliche Kristallziehprozesse zu vergleichen und denjenigen Prozess auszuwählen, der das Potenzial hat, keine dotierstoffbedingten Versetzungen zu generieren. Der Vorteil dieser Methode liegt dabei darin, dass keine weiteren teuren Experimente durchgeführt werden müssen.

Besonders bevorzugt werden zur Ermittlung der Konstante $C_{Offset}$ mehrere unterschiedliche Prozesse einer Prozessklasse getestet, wobei für jede Prozessklasse eine gemittelte Konstante $C_{Offset}$ bestimmt wird, indem die Einzelwerte arithmetisch gemittelt werden.

Die Erfinder haben dabei erkannt, dass es sinnvoll sein kann, Prozessklassen zu definieren, indem Prozesse mit gleichen Prozesseigenschaften zu einer Prozessklasse zusammengefasst werden. Diese Eigenschaften sind zum Beispiel der Nenndurchmesser des zu ziehenden Kristalls oder die Verwendung eines Magnetfeldes beim Kristallziehen. Besonders bevorzugt wird die Prozessklasse definiert durch Prozesse gleichen Nenndurchmessers der Kristalle.

**Figur 2** zeigt exemplarisch die Summe aus dem simulierten Parameter $\overline{CS}$ und einer Offsetkonstante $C_{Offset}$ für einen Beispielprozess **A** dargestellt als Funktion des Widerstandes (gestrichelte Kurve). Der Grenzwiderstand, bei dem der Kristall gerade noch ziehbar ist, wird ermittelt, indem der Widerstand so lange variiert wird, bis die Kurve aus der Summe aus dem simulierten Parameter $\overline{CS}$ am Tripelpunkt des simulierten Kristalls und der Offsetkonstante $C_{Offset}$ null wird.

Der eingezeichnete dunkel gefärbte Balken soll den Bereich zeigen, bei welchem Widerstandsbereich ein Kristallziehen aussichtslos ist. Realistischerweise gibt es einen kleinen Übergangsbereich (hell schraffiert), bei dem ein Kristallziehen mit hohem Risiko möglich ist, jedoch aus wirtschaftlichen Gründen nicht zu empfehlen ist.

**Figur 3** zeigt die Summe aus dem simulierten Parameter $\overline{CS}$ am Tripelpunkt des jeweiligen Kristalls und einer Offsetkonstante $C_{Offset}$ für vier Beispielprozesse (**A** "gestrichelt", **B** "voll", **C** "strichpunkt", **D** "strichpunktpunkt") jeweils dargestellt als Funktion des Widerstandes.

Die jeweiligen Grenzwiderstände, bei dem ein Kristall gerade noch ziehbar ist, wurde durch die nach unten gerichteten Pfeile auf die Abszissenachse symbolisiert.

## Patentansprüche

1. Verfahren zum Kristallziehen eines monokristallinen Kristalls aus einer Schmelze aus Silicium und einem Dotierstoff nach Czochralski enthaltend die Schritte in gegebener Reihenfolge:

(a) das Durchführen einer zeitabhängigen Computersimulation eines vordefinierten Kristallziehprozesses mit einer vordefinierten Dotierstoffkonzentration C in der Schmelze, mit dem Ziel für jeden Zeitschritt t einen Temperaturgradienten $\partial T/\partial n$, und einen Gradienten des Dotierstoffes $\partial c/\partial n$ zu erhalten, wobei beide Gradienten an der Grenzfläche zwischen Kristall und Schmelze in Richtung der Normalen der Grenzfläche zur Schmelze hin ermittelt werden,
(b) das Ermitteln einer maximalen Dotierstoffkonzentration $C_{max}$ in der Schmelze und
(c) das Ziehen eines Einkristalls mit Dotierstoffkonzentration kleiner als der ermittelten maximalen Dotierstoffkonzentration $C_{max}$,

**dadurch gekennzeichnet, dass**

für jeden Zeitschritt t eine Größe **CS** berechnet wird, die bestimmt wird durch die Formel **CS** = $\partial T/\partial n$ - **$f_{CS}$** $\partial c/\partial n$, wobei der Parameter $f_{CS}$ bestimmt wird durch das Produkt aus der mittleren Konzentration des Dotierstoffes C in der Schmelze, der Dichte der Siliziumschmelze, der Avogadrokonstante, der molare Masse von Silicium und der Steigung der Liquiduslinie,
und anschließend einen Mittelwert $\overline{CS}$ aus den erhaltenen Werte der Größe CS zu bilden, wobei nur diejenigen Werte einen Beitrag leisten, deren Wert CS kleiner ist als Null
und das Ermitteln einer maximalen Dotierstoffkonzentration $C_{max}$ durch das Anpassen der vordefinierten Dotierstoffkonzentration C bis der Betrag von $\overline{CS}$ gleich Null ist.

2. Verfahren nach Anspruch 1, **dadurch gekennzeichnet, dass** die Größe $\overline{CS}$ am Tripelpunkt des Kristalles ermittelt wird.

3. Verfahren nach Anspruch 1 oder 2, **dadurch gekennzeichnet, dass** Ermitteln einer maximalen Dotierstoffkonzentration $C_{max}$ durch das Anpassen der vordefinierten Dotierstoffkonzentration C bis der Betrag von CS - $C_{Offset}$ gleich Null ist, wobei $C_{Offset}$ empirisch ermittelt wird, indem einer oder mehrere Kristalle gezogen werden, wobei sukzessive die Dotierstoffkonzentration erhöht wird, solange bis der Kristall reproduzierbar Versetzungen aufweist.

**Claims**

1. A method of crystal pulling of a monocrystalline crystal from a melt composed of silicon and a dopant according to Czochralski, comprising the following steps in the sequence given:

(a) performing a time-dependent computer simulation of a predefined crystal pulling process with a predefined dopant concentration C in the melt, with the aim of obtaining a temperature gradient $\partial T/\partial n$, and a gradient of the dopant $\partial c/\partial n$ for each time increment t, where the two gradients are ascertained at the interface between crystal and melt in the normal direction of the interface to the melt,
(b) ascertaining a maximum dopant concentration $C_{max}$ in the melt and
(c) pulling a single crystal with a dopant concentration less than the ascertained maximum dopant concentration $C_{max}$ wherein,
a parameter CS is calculated for each time increment t, which is determined via the formula

$$CS = \partial \mathrm{T}/\partial \mathrm{n} - f_{CS}\ \partial \mathrm{c}/\partial \mathrm{n},$$

where the parameter $f_{CS}$ is determined by the product of the average concentration of the dopant C in the melt, the density of the silicon melt, Avogadro's constant, the molar mass of silicon and the slope of the liquidus line, and then an average $\overline{CS}$ of the values obtained for the parameter CS is formed, where a contribution is made only by those values having a CS value of less than zero, and a maximum dopant concentration $C_{max}$ is ascertained by fitting the above-defined dopant concentration C to the magnitude of $\overline{CS}$ = zero.

2. The process as claimed in claim 1, wherein
the parameter $\overline{CS}$ is ascertained at the triple point of the crystal.

3. The process as claimed in claim 1 or 2, wherein
a maximum dopant concentration $C_{max}$ is ascertained by the fitting of the above-defined dopant concentration C until the magnitude of $\overline{CS}$ - $C_{Offset}$ = zero, where, $C_{Offset}$ is ascertained empirically by pulling one or more crystals, while gradually increasing the dopant concentration until the crystal reproducibly has dislocations.

**Revendications**

**1.** Procédé de tirage d'un cristal monocristallin à partir d'une masse fondue de silicium et d'un dopant selon Czochralski, contenant les étapes suivantes, dans l'ordre indiqué :

(a) la réalisation d'une simulation informatique en fonction du temps d'un procédé de tirage de cristal prédéfini à une concentration en dopant C prédéfinie dans la masse fondue, dans le but d'obtenir, pour chaque pas temporel t, un gradient de température $\partial T/\partial n$, et un gradient du dopant $\partial c/\partial n$, les deux gradients étant déterminés à l'interface entre le cristal et la masse fondue dans la direction de la normale à l'interface avec la masse fondue,
(b) la détermination d'une concentration maximale en dopant $C_{max}$ dans la masse fondue et
(c) le tirage d'un monocristal présentant une concentration en dopant inférieure à la concentration maximale en dopant $C_{max}$ déterminée,

**caractérisé en ce que**

pour chaque pas temporel t, une grandeur CS est calculée, qui est déterminée par la formule

$$CS = \partial T / \partial n - f_{CS} \; \partial c / \partial n,$$

le paramètre $f_{CS}$ étant déterminé par le produit de la concentration moyenne en dopant C dans la masse fondue, de la masse volumique de la masse fondue de silicium, de la constante d'Avogadro, de la masse molaire de silicium et de la pente de la ligne de liquidus,
et ensuite, à former une valeur moyenne $\overline{CS}$ à partir des valeurs obtenues de la grandeur CS, seules les valeurs dont la valeur CS est inférieure à zéro, apportant une contribution
et la détermination d'une concentration maximale en dopant $C_{max}$ par l'adaptation de la concentration en dopant C prédéfinie jusqu'à ce que la contribution de $\overline{CS}$ soit égale à zéro.

**2.** Procédé selon la revendication 1, **caractérisé en ce que** la grandeur $\overline{CS}$ est déterminée au niveau du point triple du cristal.

**3.** Procédé selon la revendication 1 ou 2, **caractérisé en ce que**
la détermination d'une concentration maximale en dopant $C_{max}$ par l'adaptation de la concentration en dopant C prédéfinie jusqu'à ce que la contribution de $\overline{CS}$ - $C_{Offset}$ soit égale à zéro, $C_{Offset}$ étant déterminé empiriquement **en ce que** un ou plusieurs cristaux sont tirés, la concentration en dopant étant augmentée successivement, tant que le cristal présente des décalages reproductibles.

Figur 1

Figur 2

Figur 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102019210254 A1
- EP 3864197 A1
- DE 102021206550 A1

**In der Beschreibung aufgeführte Nicht-Patentliteratur**

- **Y. MUKAIYAMA et al.** *J. Cryst. Growth*, 2023, vol. 619, 127333
- **Y. MUKAIYAMA et al.** *J. Cryst. Growth*, 2020, vol. 532, 125433
- **VON L. STOCKMEIER**. Heavily n-type doped silicon and the dislocation formation during its growth by the Czochralski method. *Dissertation*, ISBN 978-3-8396-1345-0
- **Y. MUKAIYAMA** ; **V. ARTEMYEV** ; **K. SUEOKA**. *J. Crystal Growth*, 2022, vol. 597, 126844, https://doi.org/10.1016/j.jcrysgro.2022.126844
- **Y. MUKAIYAMA** ; **V. ARTEMYEV** ; **K. SUEOKA**. *J. Crystal Growth*, 2022, vol. 597, 126844